# EUROPÄISCHE PATENTANMELDUNG

(11) **EP 1 940 207 A2**
(43) Veröffentlichungstag der Anmeldung: **02.07.2008**
(21) Anmeldenummer: 07122615.3
(22) Anmeldetag: 07.12.2007
(51) Int. Cl.: H05K 1/11, H05K 3/34

(54) **Elektrische Vorrichtung mit einem Trägerelement mit zumindest einer speziellen Anschlussfläche und einem oberflächenmontierten Bauelement**

(30) Priorität: 28.12.2006 DE 102006062494
(71) Anmelder: ROBERT BOSCH GMBH, 70442 Stuttgart (DE)
(72) Erfinder: Klein, Christian, 70469, Stuttgart (DE); Finzer, Guido, 71701, Schwieberdingen (DE); Haalboom, Thomas, 75433, Maulbronn (DE); Haiss, Eberhard, 72417, Jungingen (DE)

(57) **Zusammenfassung**

Es wird eine elektrische Vorrichtung mit einem Trägerelement (11), insbesondere einer Leiterplatte, vorgeschlagen. Diese Vorrichtung weist zumindest eine auf dem Trägerelement (11) angeordnete Anschlussfläche (16) auf, die zur Kontaktierung eines Bauelements (50) dient. Die Öffnung ist dadurch gekennzeichnet, dass die benetzbare Anschlussfläche (16) jeweils aus zumindest zwei Teilflächen (28, 31) besteht, wobei eine der Teilflächen (28) schmaler als die andere Teilfläche (31) ist.

## Beschreibung

### Stand der Technik

Die Erfindung betrifft eine elektrische Vorrichtung mit einem Trägerelement, insbesondere einer Leiterplatte mit zumindest einer auf dem Trägerelement angeordneten Anschlussfläche sowie ein auf dieser Anschlussfläche stoffschlüssig befestigtes oberflächenmontiertes Bauelement.

Aus der japanischen Offenlegungsschrift JP-06140753 A ist eine elektrische Vorrichtung der eingangs genannten Art bekannt. Aus diesem Stand der Technik ist bekannt, mittels spezieller Geometrien der Anschlussflächen ein Aufrichten von Chipbauteilen und somit eine Fehlausrichtung dieser Teile zu verringern. Desweiteren sind allgemein bei der Verwendung bzw. Kontaktierung von oberflächenmontierten Elektrolytkondensatoren Anschlussflächen bekannt, die üblicherweise in Rechteckform ausgeführt sind, wobei sich die schmalen Seiten zweier Anschlussflächen gegenüber stehen.

Nachteilig ist bei derartigen Anschlussflächen, dass es bei der Verarbeitung in Reflow-Lötanlagen zum Verschwimmen der Bauelemente kommen kann. Verschwimmen der Bauelemente bedeutet, dass die oberflächenmontierten Bauelemente keine Ideallage einnehmen, sondern vielmehr die Lötverbindung zwischen dem bauelementseitigen Anschluss und der Anschlussfläche auf der Trägerplatte nur unbefriedigend ausgeführt ist, weil beispielsweise die Lötverbindung nur mit geringer Lotmasse hergestellt ist. Die Ausfallraten sind damit relativ hoch und bedeuten einen Mehraufwand an Reparatur.

Beide vorgenannten Gestaltungen der Anschlussflächen sind nicht dazu geeignet, eine verhältnismäßig genaue Positionierung von oberflächenmontierbaren Bauelementen zu gewährleisten.

### Offenbarung der Erfindung

Mit der erfindungsgemäßen Vorrichtung nach den Merkmalen des unabhängigen Anspruchs ist es dem gegenüber möglich, das Verschwimmen des Bauelements zu reduzieren und somit die Positionsgenauigkeit (Verdrehung) deutlich zu verbessern. Zudem ist über die weniger schmale Teilfläche eine sehr gute Anbindung und Festigkeit zwischen Anschlussfläche und Kontakt des Bauelements gegeben.

Durch die in den Unteransprüchen aufgeführten Maßnahmen ergeben sich vorteilhafte Weiterbildungen und Verbesserungen der im Anspruch 1 angegebenen Merkmale.

Sieht man zwischen den zwei Teilflächen eine Fläche vor, die einen Übergang zwischen beiden Teilflächen darstellt und vorzugsweise trapezförmig ist, so erhält man eine gute Lotausbreitung von der nicht schmalen Teilfläche zur schmalen Teilfläche. In der Folge ist eine Verbindung zwischen dem Kontakt des Bauelements und der Anschlussfläche besonders großflächig und gleichzeitig gut ausgerichtet.

Ordnet man mehrere Anschlussflächen eines oberflächenmontierten Bauelements derartig zueinander an, dass die Anschlussflächen in einem Winkel zueinander angeordnet sind, der aus dem Quotienten aus 360° und der Anzahl n der Anschlussflächen besteht, so erhält man eine Anordnung der Anschlussflächen für das Bauelement, die eine geradezu ideal zentrierte Ausrichtung der Bauelemente zu den Anschlussflächen ermöglicht.

Letztgenanntes Merkmal ist ganz besonders dann von Vorteil, wenn die Anschlussflächen zu einem gemeinsamen Zentrum orientiert sind.

Gemäß einer weiteren Ausgestaltung der Erfindung ist vorgesehen, dass die Anschlussflächen mit der nicht schmalen Seite einander zugewandt sind. Dies hat den Vorteil, dass bei geeigneter Anordnung der Kontakte des Bauelements auf der Anschlussfläche eine besonders gute Hebelwirkung zwischen Anschlussfläche und Kontakt des Bauelements erreicht wird und somit eine besonders leichte (Kräfte aus der Oberflächenspannung des flüssigen Lots) Ausrichtung des Bauelements während des Lötens gelingt.

Für den Fall, dass die nicht schmalen Seiten der Anschlussflächen nicht unter dem Bauelement angeordnet sein sollen, kann auch vorgesehen sein, die schmalen Seiten der Anschlussflächen einander zugewandt auf dem Trägerelement anzuordnen.

Um eine besonders zuverlässige Ausrichtung der Kontaktelemente der Bauelemente auf den Anschlussflächen zu erreichen, ist vorgesehen, dass diese im Bereich des Übergangs der Teilflächen und auf den schmalen Teilflächen mit den Anschlussflächen verbunden sind.

Eine gute Ausrichtung der Kontakte auf den Anschlussflächen ist dann gegeben, wenn die Kontakte des Bauelements eine in etwa ähnliche Breite wie die schmalen Teilflächen der Anschlussflächen aufweisen bzw. vorzugsweise schmaler als die schmalen Teilflächen sind.

Gemäß einem weiteren Teilaspekt der Erfindung ist vorgesehen, dass eine Kontur der tatsächlichen Anschlussflächen durch Maskierung einer größeren metallisierten Fläche auf dem Trägerelement mittels eines isolierenden Stoffs, vorzugsweise eines Lacks oder eines lackähnlichen Stoffs, konturiert ist.

### Kurze Beschreibung der Zeichnungen

Im Folgenden wird die Erfindung anhand einiger Figuren näher erläutert.

Es zeigen:
Figur 1 ausschnittweise ein Trägerelement, das auf einer Oberfläche zwei Anschlussflächen trägt,
die Figuren 2a, 2b und 2c jeweils einen Querschnitt durch ein Trägerelement und eine Anschlussfläche,
Figur 3 ein zweites Ausführungsbeispiel der elektrischen Vorrichtung mit einem Trägerelement und darauf angeordneten Anschlussflächen,
Figur 4 ein drittes Ausführungsbeispiel einer Anschlussfläche,
Figur 5 ein weiteres Ausführungsbeispiel einer Anschlussfläche,
Figur 6 eine Anordnung von mehreren Anschlussflächen,die um einen Mittelpunkt herum angeordnet sind,
Figur 7 zeigt eine Schnittdarstellung durch die Anordnung gemäß Figur 6,
Figur 8 eine Darstellung von Kontaktflächen auf Anschlussflächen in einer Draufsicht.

### Ausführungsformen der Erfindung

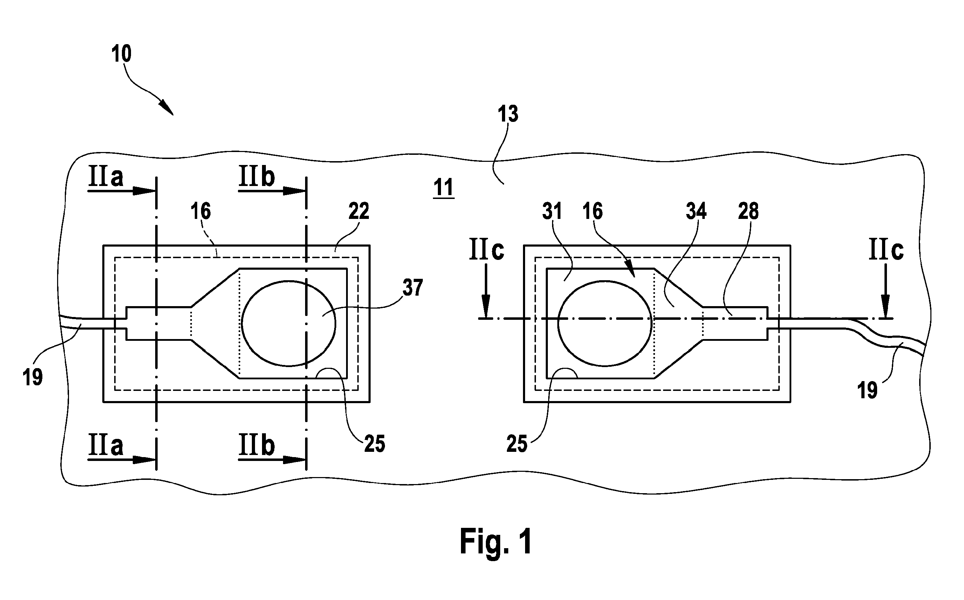

Figur 1 zeigt ausschnittweise ein Trägerelement 10, das auf einer Oberfläche 13 zwei Anschlussflächen 16 trägt. Diese Anschlussflächen 16 dienen dazu, ein in der Figur 1 nicht dargestelltes Bauelement elektrisch zu kontaktieren. Die Anschlussflächen 16 sind jeweils mit einer elektrischen Zuleitung 19 miteinander verbunden. Die Anschlussfläche 16 besteht aus einer leitfähigen Schicht, die beispielsweise aus Kupfer oder Silber besteht (Metallisierung). Die Anschlussfläche 16 stellt damit eine metallische Kaschierung da, die vom Trägerelement 11 getragen ist. Im genannten Ausführungsbeispiel gemäß Figur 1 ist die eigentliche Anschlussfläche 16 zum Teil durch eine Maske 22 abgedeckt. Diese Maske 22, beispielsweise ein sogenannter Lötstopplack, dient dazu, die tatsächliche Anschlussfläche 16, welche durch das Lot benetzbar ist, zu begrenzen. Hierfür weist die Maske 22 eine Innenkontur 25 auf. Spiegelsymmetrisch zu der Anordnung auf der linken Seite der Figur 1 ist eine weitere Anschlussfläche 16 dargestellt. Die tatsächliche Anschlussfläche 16 ist durch die Innenkontur 20 der Maske 22 in drei Teilflächen unterteilt. Eine erste Teilfläche 28 ist in der rechten Hälfte der Figur 1 rechts dargestellt. Eine weitere Teilfläche 31 ist dort links dargestellt. Beide Teilflächen 28 und 31 sind hier im Beispiel durch eine dritte Teilfläche, die hier als Übergangsfläche 34 bezeichnet ist, einstückig verbunden und beabstandet. Letztlich bilden alle drei Teilflächen eine gemeinsame Teilfläche, die zur Benetzung mit dem Lot dienen kann. Desweiteren zeigt Figur 1 auf jeder der Anschlussflächen 16 ein Lotdepot 37, das in einem weiteren Schritt während des Lötprozesses dann aufgeschmolzen wird. In Figur 1 ist demzufolge ausschnittweise die elektrische Vorrichtung 10 mit einem Trägerelement 11 dargestellt, das hier insbesondere als Leiterplatte, beispielsweise gedruckte Leiterplatte, ausgeführt ist. Desweiteren weist die elektrische Vorrichtung 10 zumindest eine auf dem Trägerelement 11 angeordnete Anschlussfläche 16 auf, die zur Kontaktierung eines oberflächenmontierten Bauelements (SMD-Bauelement) dient. Die von Lot benetzbare Anschlussfläche 16 besteht aus zumindest zwei Teilflächen 28 und 31, wobei die Teilfläche 28 schmaler als die andere Teilfläche 31 ist.

Desweiteren ist in Figur 1 gezeigt, dass zwischen den zwei Teilflächen 28 und 31 eine Übergangsfläche 34 angeordnet ist, die einen Übergang zwischen beiden Teilflächen 28 und 31 bildet und vorzugsweise trapezförmig ist. Die Übergangsfläche 34 bildet eine Verbindung zwischen der schmalen Teilfläche 28 und der breiten Teilfläche 31.

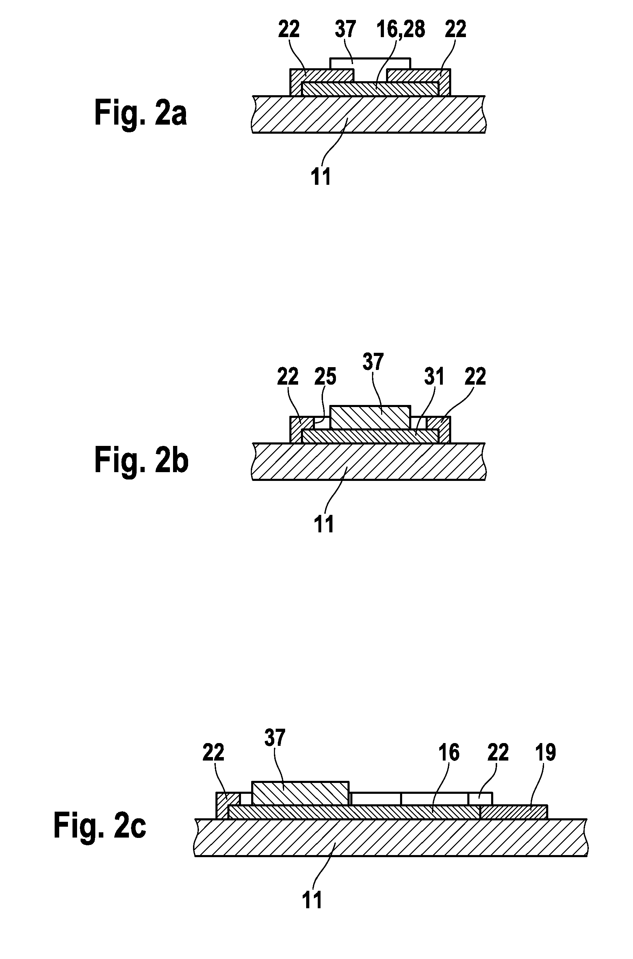

Figur 2a zeigt einen Querschnitt durch das Trägerelement 11 an der in Figur 1 markierten Stelle. Wie deutlich zu erkennen ist, sitzt auf dem Trägerelement 11 die Anschlussfläche 16, die zu einem großen Teil durch die Maske 22 abgedeckt ist. Die Maske 22 bedeckt zumindest einen Teil der Anschlussfläche 16 als auch die Seitenflächen der Anschlussflächen.

Der Schnitt gemäß Figur 2b zeigt einen Schnitt durch das Lotdepot 37 auf der Teilfläche 31. Der Schnitt gemäß Figur 2c zeigt einen Längsschnitt durch die Anschlussfläche 16 und das Lotdepot 37 und verdeutlicht die Anordnung der Anschlussflächen 16 mit Maske 22.

Wie in Figur 1 dargestellt, ist erkennbar, dass die benetzbaren Oberflächenbereiche der Anschlussfläche 16 zu einem gemeinsamen Zentrum hin, das zwischen den beiden Anschlussflächen 16 liegt, erweitert sind.

Beide benetzbaren Anschlussflächen 16 sind mit der breiten Seite einander zugewandt.

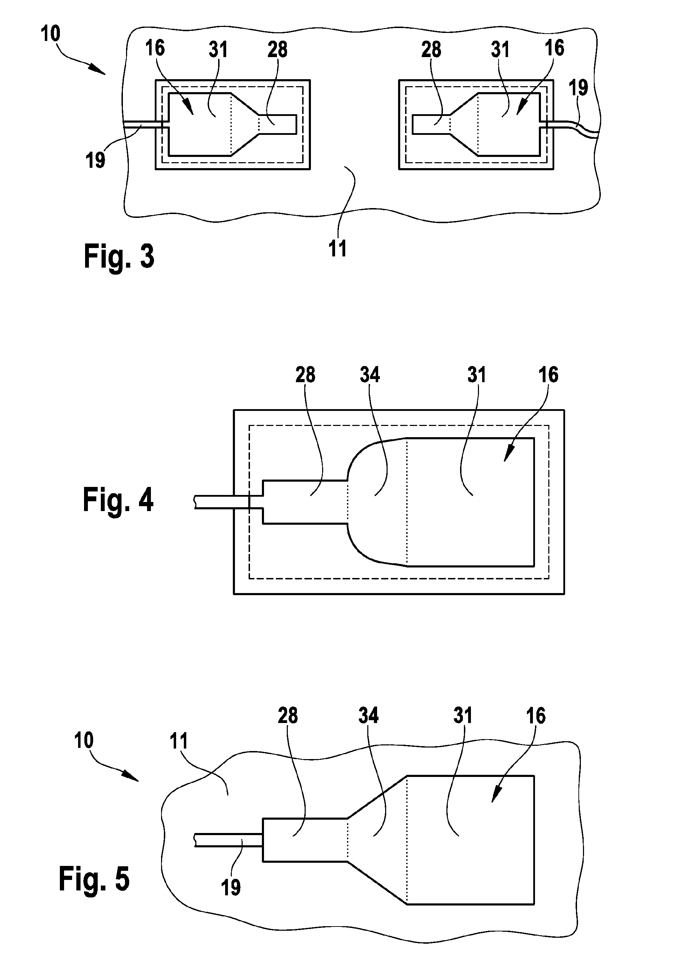

Figur 3 zeigt ein zweites Ausführungsbeispiel der elektrischen Vorrichtung mit einem Trägerelement 11 und darauf angeordneten Anschlussflächen 16.

Für den Fall, dass es nicht möglich ist die breiten Teilflächen 31 unter dem Bauelement anzuordnen, kann auch vorgesehen sein, die schmalen Teilflächen 28 der Anschlussflächen 16 einander zugewandt auf dem Trägerelement 11 anzuordnen.

Figur 4 zeigt ein drittes Ausführungsbeispiel einer Anschlussfläche 16, wobei hier im Unterschied zum Ausführungsbeispiel gemäß Figur 1 die Übergangsfläche 34 nicht trapezförmig sondern angenähert halbkreisförmig ausgeführt ist. Für diese Übergangsflächen 34 sind prinzipiell verschiedene Ausführungsformen möglich. Wesentlich ist hierbei - sofern eine Übergangsfläche 34 vorgesehen ist - dass diese einen Übergang von der breiten Teilfläche 31 zur schmalen Teilfläche 28 ermöglicht.

Figur 5 zeigt ein weiteres Ausführungsbeispiel einer Anschlussfläche 16. In diesem Ausführungsbeispiel besteht die Anschlussfläche 16 nicht aus einer Kaschierung aus einem leitfähigen Material, das von einer Maske 22 konturiert ist, sondern vielmehr ist die Anschlussfläche 16 selbst derartig konturiert, beispielsweise fotochemisch hergestellt, dass diese Fläche 16 sowohl die Teilfläche 31, Teilfläche 28 als auch die Übergangsfläche 34 aufweist. In einer nicht dargestellten Variante kann diese Fläche 16 auch nur aus der Teilfläche 31 und der Teilfläche 28 bestehen.

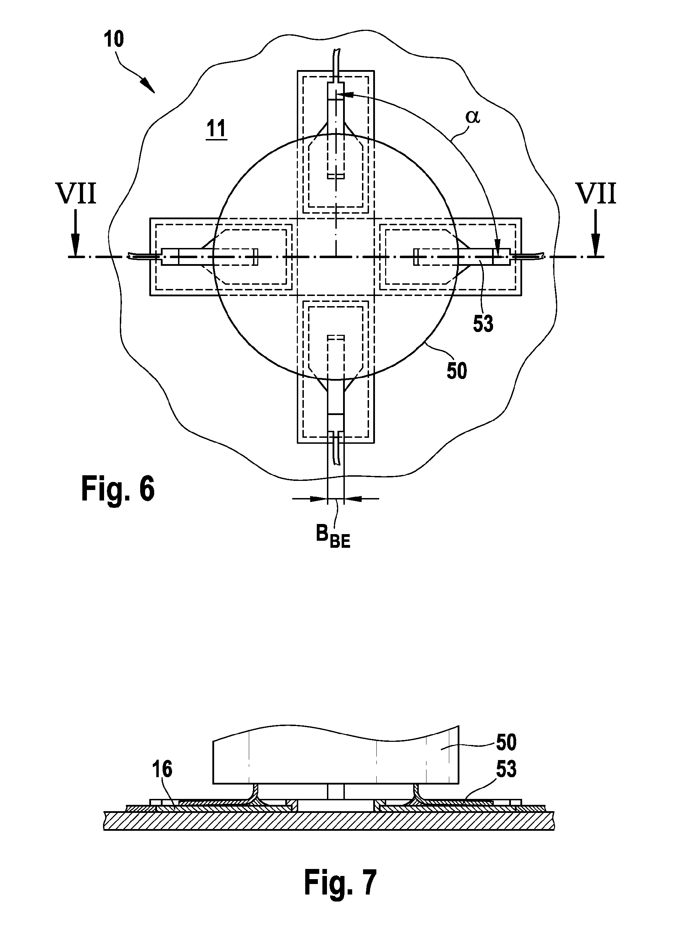

Figur 6 zeigt eine Vielzahl von Anschlussflächen 16, die um einen gemeinsamen Mittelpunkt herum angeordnet sind. Diese Anordnung stellt in diesem Fall die Anschlusskontakte für ein Bauelement dar, das nur mittels einer angedeuteten Umrisslinie 50 dargestellt ist. Das Bauelement 50 weist in diesem Beispiel vier Kontakte 53 auf, die auf den Anschlussflächen 16 angeordnet sind. Alle vier Anschlussflächen sind um einen Winkel α, der in diesem Fall gleichmäßig ist, beabstandet. Figur 6 zeigt somit eine elektrische Vorrichtung 10 mit einem Trägerelement 11, wobei hier mehrere Anschlussflächen 16 einem Bauelement 50 zugeordnet sind. Dieses Bauelement ist in diesem Beispiel ein oberflächenmontiertes Bauelement (SMD-Bauelement). Die Anschlussflächen 16 sind in einem Winkel α zueinander angeordnet, der in diesem speziellen Beispiel den Quotienten aus 360° und der Zahl n besteht. n ist hierbei die Anzahl der Kontakte 53 oder die Anzahl der Anschlussflächen 16, die dazu dienen, das Bauelement 50 zu kontaktieren.

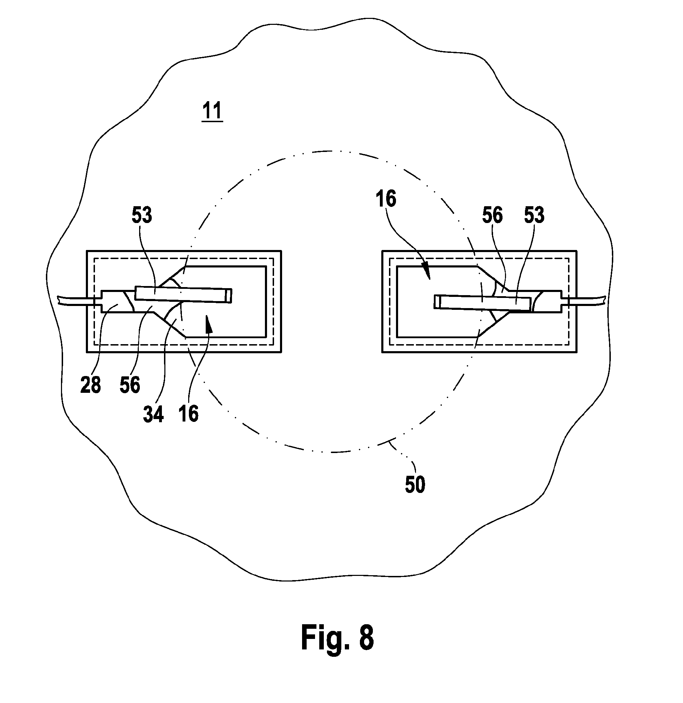

Figur 7 zeigt eine Schnittdarstellung durch die Anordnung gemäß Figur 6. Wie in Zusammenschau mit Figur 6 erkennbar ist, hat das oberflächenmontierte Bauelement 50 Kontaktfahnen 53, die derartig zueinander angeordnet sind, dass diese im Bereich der Übergangsfläche 34 mit den Anschlussflächen 16 verbunden sind. Die Kontakte 53 des Bauelements 50 haben eine in etwa ähnliche Breite B_{BE} wie die schmalen Teilflächen 28, Figur 8. In einer bevorzugten Ausführungsform sind die Kontakte 53 des Bauelements 50 schmaler als die Teilflächen 28. Die Kontakte 53 des Bauelements 50 sind auf den Anschlussflächen 16 während des Lötprozesses verschwommen, aber durch die Übergangsflächen 34 und das darauf angeordnete Lot 56 mittels der Oberflächenspannung des noch flüssigen Lots ausgerichtet.

## Patentansprüche

1. Elektrische Vorrichtung (10) mit einem Trägerelement (11), insbesondere Leiterplatte, mit zumindest einer, auf dem Trägerelement (11) angeordneten Anschlussfläche (16), die zur Kontaktierung eines Bauelements (50) dient, **dadurch gekennzeichnet, dass** die mit Lot (56) benetzbare Anschlussfläche (16) aus zumindest zwei Teilflächen (28, 31) besteht, wobei eine der Teilflächen (28) schmaler als die andere Teilfläche (31) ist.

2. Elektrische Vorrichtung nach Anspruch 1, **dadurch gekennzeichnet, dass** zwischen den zwei Teilflächen (28, 31) eine Übergangsfläche (34) angeordnet ist, die ein Übergang zwischen beiden Teilflächen (28, 31) ist und vorzugsweise trapezförmig ist.

3. Elektrische Vorrichtung nach einem der vorstehenden Ansprüche, **dadurch gekennzeichnet, dass** mehrere Anschlussflächen (16) einem Bauelement (50) zugeordnet sind, wobei die Anschlussflächen (16) in einem Winkel α zueinander angeordnet sind, der dem Quotienten aus 360° und n besteht, wobei n die Anzahl der Kontakte (53) ist, die dazu dienen, das Bauelement (50) zu kontaktieren.

4. Elektrische Vorrichtung nach einem der vorstehenden Ansprüche, **dadurch gekennzeichnet, dass** mehrere Anschlussflächen (16) zu einem gemeinsamen Zentrum orientiert sind.

5. Elektrische Vorrichtung nach einem der vorstehenden Ansprüche, **dadurch gekennzeichnet, dass** die Anschlussflächen (16) einander mit der breiten Seite zugewandt sind.

6. Elektrische Vorrichtung nach Anspruch 4, **dadurch gekennzeichnet, dass** schmale Seiten der Anschlussflächen (16) einander zugewandt sind.

7. Elektrische Vorrichtung nach einem der vorstehenden Ansprüche, **dadurch gekennzeichnet, dass** das Bauelement (50) Kontakte (53) aufweist, die derartig angeordnet sind, dass diese im Bereich der Übergangsfläche (34) der Teilflächen (28, 31) mit den Anschlussflächen (16) verbunden sind.

8. Elektrische Vorrichtung nach Anspruch 7, **dadurch gekennzeichnet, dass** die Kontakte (53) des Bauelements (50) eine in etwa ähnliche Breite (B_{BE}) wie die schmalen Teilflächen (28) aufweisen, vorzugsweise schmaler sind.

9. Elektrische Vorrichtung nach einem der vorstehenden Ansprüche, **dadurch gekennzeichnet, dass** die für die Kontaktierung vorgesehene Anschlussfläche (16) durch eine Maske (22) auf einer größeren Metallisierungsfläche auf dem Trägerelement (11) konturiert ist.
